# EUROPÄISCHE PATENTSCHRIFT

(11) **EP 1 211 140 B1**
(45) Veröffentlichungstag und Bekanntmachung des Hinweises auf die Patenterteilung: **14.09.2005**
(21) Anmeldenummer: 01128351.2
(22) Anmeldetag: 30.11.2001
(51) Int. Cl.: B60R 16/02

(54) **Gehäuse für ein elektronisches Überwachungsgerät an Fahrzeugteilen**
Housing for an electronic monitoring device on vehicle parts
Boitier pour un appareil électronique de surveillance fixé à des parties de véhicule

(30) Priorität: 01.12.2000 DE 20020392 U
(43) Veröffentlichungstag der Anmeldung: 05.06.2002
(73) Patentinhaber: TRW Automotive Electronics & Components GmbH & Co. KG, 78315 Radolfzell (DE)
(72) Erfinder: Peter, Cornelius, 77815 Bühl (DE)
(74) Vertreter: Degwert, Hartmut

(56) Entgegenhaltungen:
- DE-C- 19 709 243
- US-A- 4 626 962
- US-A- 5 535 098

## Beschreibung

Die Erfindung betrifft ein Gehäuse für ein elektronisches Überwachungsgerät an Fahrzeugteilen, insbesondere an einem Blei-Akkumulator.

Herkömmliche Gehäuse für elektronische Überwachungsgeräte an Fahrzeugteilen werden aus Metall oder Kunststoff hergestellt. Metallische Gehäuse haben eine Grundplatte, mit der die Befestigung an dem Fahrzeugteil erfolgen kann. Gehäuse aus Kunststoff können zum Zweck der Befestigung mit angeformten Laschen oder Flanschen versehen werden.

Die DE 19 709 243 C offenbart ein gehäuse nach dem Oberbegriff des Anspruchs 1, insbesondere ein Gehänse mit einer metallischen Grundplatte und einem Gehäusekörper aus Kunststoff. Die Grundplatte wird mit Schrauben o.dgl. an dem Gehäusekörper verbunden.

Durch die Erfindung wird ein Gehäuse für ein elektronisches Überwachungsgerät zur Verfügung gestellt, das preiswert in Großserie herstellbar ist und allen mechanischen und elektrischen Anforderungen genügt. Das Gehäuse hat eine tragende metallische Grundplatte und einen, erfindungsgemäß, durch Umspritzen der Grundplatte gebildeten, allgemein quaderförmigen Gehäusekörper. Die Grundplatte ragt auf wenigstens einer Seite mit einem freitragenden Befestigungsabschnitt aus dem Gehäusekörper heraus. Das Gehäuse eignet sich besonders zur Aufnahme eines elektronischen Ladezustandsanzeigers für Blei-Akkumulatoren. Durch den freitragenden Befestigungsabschnitt ist eine unmittelbare Befestigung an einer geeignet ausgebildeten Polklemme möglich. Es sind Polklemmen bekannt, bei denen relativ dicke elektrische Kabel an hochragenden Stehbolzen angeschlossen werden. Wenn der Befestigungsabschnitt mit entsprechenden Befestigungsöffnungen versehen wird, kann er unmittelbar auf den Stehbolzen der Polklemme befestigt werden. Der Befestigungsabschnitt dient dann zugleich der elektrischen Verbindung mit dem insbesondere positiven Batteriepol.

Bei der bevorzugten Ausführungsform wird die Grundplatte gemeinsam mit einem oder mehreren Kontaktblechen aus einem Metallblech ausgestanzt. Dabei werden die Grundplatte und die Kontaktbleche von einem äußeren Halterahmen zusammengehalten, der nach dem Umspritzen der Grundplatte an der Außenseite des geformten Gehäusekörpers abgetrennt wird.

Vorzugsweise sind ferner die Grundplatte und das Kontaktblech mit freigestanzten, senkrecht hochgebogenen Lötnägeln verbunden, die zum Eindringen in entsprechende Öffnungen einer Leiterplatte bestimmt sind, auf der die Elektronik des Geräts aufgebaut wird. Jedes Kontaktblech hat vorzugsweise eine Kontaktfahne, die aus dem Gehäusekörper herausragt und von einer am Gehäusekörper angeformten Schutzhülse umgeben ist.

Weitere Merkmale und Vorteile der Erfindung ergeben sich aus der folgenden Beschreibung einer bevorzugten Ausführungsform und aus den beigefügten Zeichnungen, auf die Bezug genommen wird. In den Zeichnungen zeigen:
- Figur 1 in Perspektivansicht eine Grundplatte und zwei Kontaktbleche, die gemeinsam aus einer Metallplatte ausgestanzt und durch einen äußeren Halterahmen verbunden sind; und
- Figur 2 eine Explosionsansicht eines elektronischen Überwachungsgeräts mit dem erfindungsgemäßen Gehäuse.

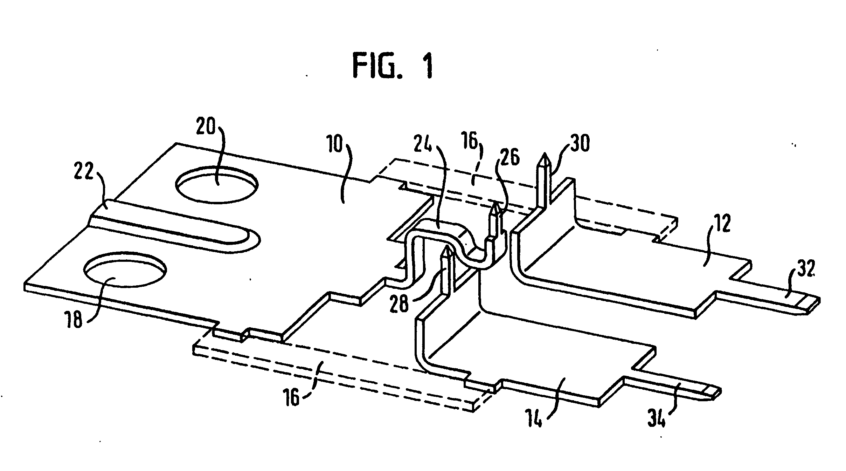

Aus einem Metallblech werden die in Figur 1 gezeigten Strukturen freigestanzt. Dazu gehören eine Grundplatte 10 und zwei Kontaktbleche 12, 14, die mit der Grundplatte 10 an seitlich abstehenden Lappen durch Haltestreifen 16 verbunden sind. Diese Haltestreifen 16 bilden einen äußeren Halterahmen, durch den die Grundplatte 10 mit den Kontaktplatten 12, 14 in einer Ebene gehalten wird, um in eine Spritzgießform eingelegt werden zu können.

Die Grundplatte 10 hat zwei kreisrunde ausgestanzte Befestigungsöffnungen 18, 20 und eine geprägte Versteifungssicke 22. Ferner ist mit der Grundplatte 10 eine Kontaktfahne 24 ausgestanzt, deren freies Ende als Lötnagel 26 geformt ist, welcher senkrecht zur Grundplatte 10 hochragt. Die Kontaktfahne 24 besteht aus zwei entgegengesetzt orientierten, U-förmigen Abschnitten, die den Lötnagel 26 in der gewünschten angehobenen Stellung halten. Der von der Grundplatte 10 abgewandte U-förmige Abschnitt bildet eine Kontaktfläche, die dazu bestimmt ist, in wärmeleitenden Kontakt mit einem Temperatursensorelement zu treten, das auf einer darüber aufsitzenden Leiterplatte aufgebaut ist. Durch die Kontaktfahne 24 ist somit eine Wärmeübertragung vom Pluspol eines Blei-Akkumulators über die Grundplatte 10 auf das Temperatursensorelement gewährleistet.

An jedem Kontaktblech 12, 14 ist ein inneres Ende senkrecht abgewinkelt und trägt einen senkrecht hochragenden Lötnagel 28, 30. Die Lötnägel 26, 28, 30 sind auf gleicher Höhe angeordnet und dazu bestimmt, in entsprechende Öffnungen einer Leiterplatte einzudringen, auf der das elektronische Überwachungsgerät aufgebaut ist, bei dem es sich vorzugsweise um eine Ladezustandsanzeige für einen Blei-Akkumulator handelt. Jede Kontaktplatte 12, 14 hat ferner eine nach außen ragende Kontaktfahne 32, 34.

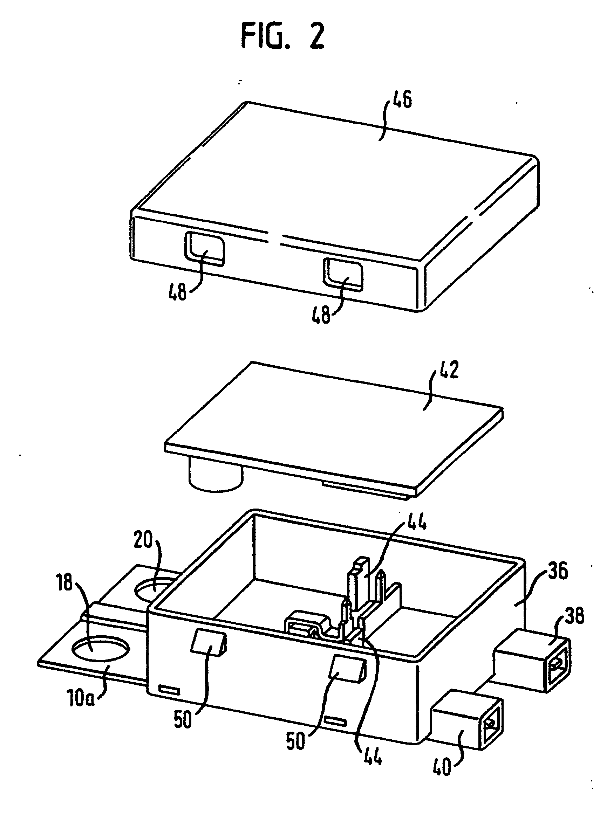

Figur 2 zeigt einen quaderförmigen Gehäusekörper 36 aus Kunststoff, der durch Umspritzen der Grundplatte 10 und der Kontaktplatten 12, 14 mit einer geeigneten Kunststoffmasse entstanden ist. Die Haltestreifen 16 (Figur 1) des äußeren Halterahmens sind abgetrennt, so daß die elektrische Verbindung zwischen Grundplatte 10 und Kontaktplatten 12, 14 entfallen ist. Auf einer Schmalseite des Gehäusekörpers 36 ragt der einen freitragenden Befestigungsabschnitt bildende Teil 10a der Grundplatte 10 heraus. Auf der gegenüberliegenden Schmalseite ragen die Kontaktfahnen 32, 34 der Kontaktbleche 12, 14 heraus. Sie sind jeweils von einer am Gehäusekörper 36 angeformten Schutzhülse 38, 40 umgeben. Die Kontaktfahnen 32, 34 sind als solche unmittelbar zum Aufschieben entsprechender Steckschuhe geeignet. An dem aus dem Gehäusekörper 36 herausragenden Befestigungsabschnitt 10a der Grundplatte 10 erfolgt die freitragende Befestigung des gesamten Geräts an einer positiven Polklemme, die mit zwei Stehbolzen versehen ist, die dann durch die Befestigungsöffnungen 18, 20 der Grundplatte 10 ragen.

Mit 42 ist in Figur 2 eine Leiterplatte bezeichnet, auf der die Elektronik des Geräts aufgebaut ist. Die Leiterplatte 42 hat Durchbrüche für die Lötnägel 26, 28 und 30. Der Gehäusekörper 36 ist mit innenseitig angeformten Stützstrukturen 44 für die Leiterplatte 42 ausgebildet.

Die der Grundplatte 10 gegenüberliegende Seite des quaderförmigen Gehäuses 36 ist offen und wird durch einen aufsetzbaren Deckel 46 verschlossen. Der Deckel 46 hat Rastöffnungen 48, die mit angeformten Rastnasen 50 am Gehäusekörper 36 zusammenwirken, um den aufgesetzten Deckel 46 mit dem Gehäusekörper 36 verbunden zu halten.

## Patentansprüche

1. Gehäuse für ein elektronisches Überwachungsgerät an Fahrzeugteilen, insbesondere an einem lei-Akkumulator, umfassend:
a) eine tragende metallische Grundplatte (10);
b) einen allgemein quaderförmigen Gehäusekörper (36);
wobei die Grundplatte (10) auf wenigstens einer Seite aus dem Gehäusekörper (36) mit einem freitragenden Befestigungsabschnitt (10a) herausragt, **dadurch gekennzeichnet, daß** der Gehäusekörper (36) durch Umspritzen der Grundplatte gebildet ist.

2. Gehäuse nach Anspruch 1, **dadurch gekennzeichnet, daß** die Grundplatte (10) aus einem Metallblech ausgestanzt ist.

3. Gehäuse nach Anspruch 1 oder 2, **dadurch gekennzeichnet, daß** mit der Grundplatte wenigstens eine Kontaktplatte (12, 14) aus dem Metallblech ausgestanzt ist, die wenigstens eine Kontaktfahne (32, 34) aufweist, die aus dem Gehäusekörper herausragt.

4. Gehäuse nach Anspruch 3, **dadurch gekennzeichnet, daß** die Kontaktfahne (32, 34) von einer am Gehäusekörper angeformten Schutzhülse (38, 40) umgeben ist.

5. Gehäuse nach einem der vorstehenden Ansprüche, **dadurch gekennzeichnet, daß** die Grundplatte wenigstens einen freigestanzten und senkrecht innerhalb des Gehäusekörpers hochgebogenen Lötnagel (26) aufweist.

6. Gehäuse nach einem der vorstehenden Ansprüche 3 bis 5, **dadurch gekennzeichnet, daß** die Kontaktplatte (12, 14) wenigstens einen freigestanzten und senkrecht innerhalb des Gehäusekörpers hochgebogenen Lötnagel (28, 30) aufweist.

7. Gehäuse nach einem der vorstehenden Ansprüche, **dadurch gekennzeichnet, daß** der Gehäusekörper innenseitig angeformte Stützstrukturen für eine Leiterplatte (42) aufweist.

8. Gehäuse nach einem der vorstehenden Ansprüche, **dadurch gekennzeichnet, daß** der Gehäusekörper (26) gegenüber der Grundplatte offen und durch einen aufgesetzten Deckel (46) verschließbar ist.

9. Gehäuse nach einem der vorstehenden Ansprüche, **dadurch gekennzeichnet, daß** der Befestigungsabschnitt (10a) der Grundplatte wenigstens eine geprägte Versteifungssicke (22) aufweist.

10. Gehäuse nach einem der vorstehenden Ansprüche, **dadurch gekennzeichnet, daß** der Befestigungsabschnitt (10a) wenigstens ein Befestigungsloch (18, 20) für den Durchgang eines Schraubbolzens aufweist, der an einer Polklemme befestigt ist.

11. Gehäuse nach einem der vorstehenden Ansprüche, **dadurch gekennzeichnet, daß** die Grundplatte eine hochgebogene Kontaktfahne (24) aufweist, die eine Anlagefläche für ein auf einer Leiterplatte aufgebautes Temperatur-Sensorelement bildet.

## Claims

1. A housing for an electronic monitoring device on vehicle parts, in particular on a lead accumulator, comprising:
a) a load-bearing metal base plate (10);
b) a generally parallelepipedal housing body (36);
the base plate (10) projecting out of the housing body (36) on at least one side with a cantilevered attachment section (10a), **characterized in that** the housing body (36) is formed by encasing the base plate by means of injection molding.

2. The housing according to claim 1, **characterized in that** the base plate (10) is stamped out of a piece of sheet metal.

3. The housing according to claim 1 or 2, **characterized in that**, together with the base plate, at least one contact plate (12, 14) is stamped out of the sheet metal that has at least one contact tag (32, 34) projecting out of the housing body.

4. The housing according to claim 3, **characterized in that** the contact tag (32, 34) is surrounded by a protective sleeve (38, 40) molded integrally with the housing body.

5. The housing according to any of the preceding claims, **characterized in that** the base plate has at least one stamped-out soldering pin (26) that is perpendicularly bent upwards inside the housing body.

6. The housing according to any of the preceding claims 3 to 5, **characterized in that** the contact plate (12, 14) has at least one stamped-out soldering pin (28, 30) that is perpendicularly bent upwards inside the housing body.

7. The housing according to any of the preceding claims, **characterized in that** the housing body comprises support structures integrally molded on the inside for a printed circuit board (42).

8. The housing according to any of the preceding claims, **characterized in that** the housing body (36) is open with respect to the base plate and can be closed by a cover (46) that is placed on.

9. The housing according to any of the preceding claims, **characterized in that** the attachment section (10a) of the base plate has at least one embossed reinforcement bead (22).

10. The housing according to any of the preceding claims, **characterized in that** the attachment section (10a) has at least one attachment hole (18, 20) for the passage of a stud which is attached to a cell terminal.

11. The housing according to any of the preceding claims, **characterized in that** the base plate has a contact tag (24) that is bent upwards and that forms a contact surface for a temperature sensor element mounted on a printed circuit board.

## Revendications

1. Boîtier pour un appareil de surveillance électronique sur des parties de véhicule, en particulier sur un accumulateur en plomb, comprenant :
a) une plaque de base (10) métallique portante ;
b) un corps de boîtier (36) généralement parallélépipédique ;
la plaque de base (10) faisant saillie sur au moins côté hors du corps de boîtier (36) avec un tronçon de fixation (10a) en porte-à-faux, **caractérisé en ce que** le corps de boîtier (36) est formé par encastrage par injection de la plaque de base.

2. Boîtier selon la revendication 1, **caractérisé en ce que** la plaque de base (10) est découpée à partir d'une tôle métallique.

3. Boîtier selon la revendication 1 ou 2, **caractérisé en ce que** conjointement avec la plaque de base, au moins une plaque de contact (12, 14) est découpée à partir de la tôle métallique, laquelle présente au moins un talon de contact (32, 34) qui fait saillie hors du corps de boîtier.

4. Boîtier selon la revendication 3, **caractérisé en ce que** le talon de contact (32, 34) est entouré par un manchon de protection (38, 40) moulé sur le corps de boîtier.

5. Boîtier selon l'une des revendications précédentes, **caractérisé en ce que** la plaque de base présente au moins un plot à souder (26) librement découpé et replié vers le haut perpendiculairement à l'intérieur du corps de boîtier.

6. Boîtier selon l'une des revendications 3 à 5, **caractérisé en ce que** la plaque de contact (12, 14) présente au moins un plot à souder (28, 30) librement découpé et replié vers le haut perpendiculairement à l'intérieur du corps de boîtier.

7. Boîtier selon l'une des revendications précédentes, **caractérisé en ce que** le corps de boîtier présente sur la face intérieure des structures de soutien moulées pour une carte de circuits imprimés (42).

8. Boîtier selon l'une des revendications précédentes, **caractérisé en ce que** le corps de boîtier (26) est ouvert par rapport à la plaque de base et peut être fermé par un couvercle (46) posé.

9. Boîtier selon l'une des revendications précédentes, **caractérisé en ce que** le tronçon de fixation (10a) de la plaque de base présente au moins une moulure de renforcement (22) estampée.

10. Boîtier selon l'une des revendications précédentes, **caractérisé en ce que** le tronçon de fixation (10a) présente au moins un trou de fixation (18, 20) pour le passage d'un boulon vissé qui est fixé sur une borne polaire.

11. Boîtier selon l'une des revendications précédentes, **caractérisé en ce que** la plaque de base présente un talon de contact (24) replié vers le haut qui forme une surface d'appui pour un élément capteur de température monté sur une carte de circuits imprimés
